Europäisches Patentamt

European Patent Office

Office européen des brevets

(19)

(11) Numéro de publication : **0 006 118**
**B1**

(12) FASCICULE DE BREVET EUROPÉEN

(45) Date de publication du fascicule du brevet :
13.07.83

(21) Numéro de dépôt : 79101349.3

(22) Date de dépôt : 03.05.79

(51) Int. Cl.³ : **H 01 L 21/205, C 30 B 25/14,
C 30 B 25/02, H 01 L 33/00**

(54) Procédé de dépôt en phase vapeur d'arséniure de gallium à forte teneur en germanium.

(30) Priorité : 12.06.78 US 914476

(43) Date de publication de la demande :
09.01.80 Bulletin 80/01

(45) Mention de la délivrance du brevet :
13.07.83 Bulletin 83/28

(84) Etats contractants désignés :
DE FR GB

(56) Documents cités :
FR A 2 067 419
FR A 2 075 325
FR A 2 149 606
FR A 2 168 193
US A 3 925 119

JOURNAL OF THE ELECTROCHEMICAL
SOCIETY, vol. 122, nr. 6, juin 1975 Princeton T. Y.
WU : « Thermochemical Analyses and Optimum
Conditions for Vapor Epitaxy of GaAs1-xPx
(0,7 × 0,9) pages 778-780.

JAPANESE JOURNAL OF APPLIED PHYSICS, vol.
16, nr. 12, décembre 1977 Tokyo (JP) K.
SUGIYAMA et al. : « Vapor Phase Epitaxial
Growth and Characterization of Ga1-y InyAs1-xPx
Quaternary Alloys » pages 2197-2203.

I.B.M. Technical Disclosure Bulletin Vol. 19. No.
10. Mars 1977. p. 3975.

(73) Titulaire : **International Business Machines Corporation**
**Old Orchard Road**
**Armonk, N.Y. 10504 (US)**

(72) Inventeur : **Marinace, John Carter**
**2096 van Cortlandt Circle**
**Yorktown Heights, N-Y. 10598 (US)**
Inventeur : **Wilkie, Earl Lawrence**
**Route No.1 Box 138**
**Putnam Valley, N.Y. 10598 (US)**

(74) Mandataire : **Klein, Daniel**
**COMPAGNIE IBM FRANCE Département de Propriété
Industrielle**
**F-06610 La Gaude (FR)**

# Procédé de dépôt en phase vapeur d'arséniure de gallium à forte teneur en germanium

## Description

## Domaine Technique

La présente invention concerne un procédé de formation par dépôt en phase vapeur d'arséniure de gallium à forte teneur en germanium. Il s'agit de fabriquer des dispositifs semi-conducteurs émetteurs de lumière dans la région bleue du spectre.

## Etat de la technique antérieure

Diverses tentatives ont été faites pour réaliser des dispositifs capables d'émettre de la lumière dans une plage de longueurs d'onde comprises entre 1 et 1,3 microns (région bleue du spectre). Jusqu'à présent, seules les solutions solides ternaires et quaternaires de composés III-V étaient capables d'émettre de la lumière dans cette plage de longueurs d'onde. Des solutions solides d'arséniure de gallium à forte teneur en germanium permettent d'obtenir un tel résultat, mais il n'existe actuellement aucune technique satisfaisante connue grâce à laquelle des quantités substantielles (35 % environ) de germanium pourraient être introduites dans de l'arséniure de gallium en vue de son utilisation à des applications électroniques.

Des composés de $GaAs_{1-x}Ge_x$ ont été réalisés conformément aux enseignements du brevet des E.U.A N° 3 979 271 en procédant à une co-pulvérisation des différents éléments. Toutefois, les proportions de ces derniers ne sont pas indiquées dans ce brevet. D'autres tentatives faisant également appel à la pulvérisation ont, par ailleurs, été signalées dans la publication intitulée « Journal of Vacuum Society Technology », Vol. 11, N° 1, janvier/février 1974.

Des brevets FR-A-2 067 419 et 2 075 325 et US-A-3 925 119 sont connus des procédés de fabrication de composés ternaires tels que d'arséniure phosphure de gallium, pour l'obtention de dispositifs émetteurs de lumière (généralement dans la gamme du route). Le brevet US-A-3 925 119 décrit dans un procédé de fabrication d'un composé $GaAs_{1-x}P_x$, un équipement comportant une chambre de réaction placée dans un four susceptible de recevoir différents composés gazeux ($HCl$, $AsH_3$ et $PH_3$). Dans la chambre de réaction sont placés des substrats GaAs dans une partie aval (par rapport aux moyens d'introduction des gaz) et une source de gallium liquide dans une partie en amont. Un gradient de température est appliqué entre ces deux parties. HCl réagit avec le gallium liquide pour fournir GaCl, qui vient se combiner avec $AsH_3$ et $PH_3$ pour donner le composé $GaAs_{1-x}P_x$ avec une valeur x désirée, selon les conditions opératoires.

## Exposé de la présente invention

La présente invention concerne un procédé de dépôt en phase vapeur d'un composé du type A $B_{1-x}C_x$ capable d'émettre dans la région bleue du spectre, permettant de commander la concentration des différents éléments constitutifs, du genre comportant les étapes suivantes :

disposer dans une chambre de réaction placée dans un four, un substrat monocristallin dans une partie dite aval et une source de l'élément le moins volatil A dans la partie amont de la chambre,

assurer un chemin distinct, pour les composés gazeux qui contiennent les éléments B et C, dont les températures et les débits peuvent être commandés, et

faire réagir un gaz halogène avec l'élément le moins volatil en fusion dans la partie « amont » maintenue à une première température $T_1$ pour fournir un gaz de réaction et mélanger lesdits gaz de réaction et composés gazeux dans la partie « aval » maintenue à une seconde température $T_2$ moins élevée que la première, au-dessus du substrat mono-cristallin sur lequel on désire déposer le composé du type A $B_{1-x}C_x$ ; caractérisé en ce que les éléments A, B et C sont respectivement le gallium, l'arsenic et le germanium, le substrat monocristallin étant de l'arséniure de gallium et en ce que $\Delta T = T_1 - T_2$ est supérieur à 100 °C pour que le coefficient x soit $> 0,04$.

D'autres objets, caractéristiques et avantages de la présente invention ressortiront mieux de l'exposé qui suit, fait en référence aux dessins annexés à ce texte, qui représentent un mode de réalisation préféré de celle-ci.

## Brève description des figures

La figure 1 représente l'appareil utilisé aux fins de la mise en œuvre du procédé de la présente invention.

La figure 2 est un profil de température illustrant la température à l'intérieur du four, qui constitue en partie l'appareil représenté sur la figure 1.

## Description de l'invention

## Introduction

La présente invention concerne un procédé permettant la formation, par dépôt en phase vapeur, d'un composé multi-éléments contenant un pourcentage important d'un élément déterminé qui se substitue progressivement à un (ou plusieurs) élément(s) dudit composé.

Ce procédé comprend l'application de composés gazeux distincts, dont on peut commander la température et la concentration, de l'élément le plus volatil dudit composé et de l'élément de substitution, en faisant réagir un composé gazeux halogéné avec l'élément le moins volatil dudit composé dans une partie d'un four qui est portée à une température élevée, et en combinant tous les composés gazeux d'un substrat disposé dans une autre partie du four qui se trouve à une température moins élevée.

De façon plus précise, on peut procéder au dépôt en phase vapeur d'arséniure de gallium à forte teneur (35 %) de germanium c'est-à-dire obéissant à la formule générale GaAs$_{1-x}$Ge$_x$ et de façon plus précise GaAs$_{100-65 \%}$ Ge$_{0-35 \%}$, pour cela on dispose des substrats de préférence mono-cristallins dans une première partie d'un four qui est maintenue à une température plus basse que celle d'une seconde partie du même four qui est située en amont de la première (par rapport à l'orifice d'introduction des gaz) et qui contient une source de gallium. Dans ce four, sont introduits de l'acide chlorhydrique et de l'hydrogène, d'une part et d'autre part un composé halogéné de germanium et un composé halogéné du plus volatil des deux composants de l'arséniure de gallium, à savoir l'arsenic. Ces composés provenant de sources distinctes, sont introduits dans la partie la moins chaude du four et se combinent avec le gallium gazeux (résultant de l'action de l'acide chlorhydrique et l'hydrogène avec le gallium en fusion), au-dessus des substrats sur lesquels le dépôt doit avoir lieu.

### Description du mode de réalisation préféré

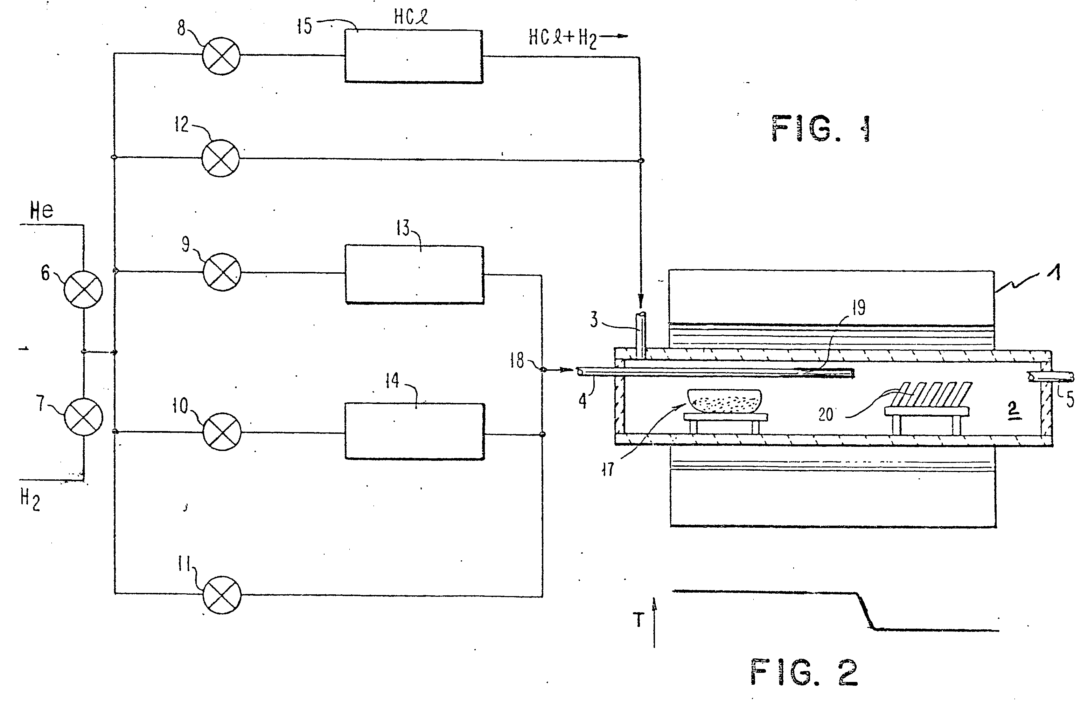

On a représenté sur la figure 1 l'appareil de dépôt qui est principalement constitué par un four 1 dans lequel peut être effectuée une opération de dépôt en phase vapeur. Le four 1 est équipé de moyens appropriés pour fournir la chaleur désirée et comporte une nacelle 2, généralement en quartz, qui délimite une enceinte à l'intérieur de laquelle la réaction doit avoir lieu. La nacelle 2 comporte au moins deux conduites d'admission 3 et 4 et au moins une conduite d'évacuation 5. La nacelle, qui constitue la chambre de réaction, est connectée à une source d'hélium et à une source d'hydrogène respectivement commandées par une valve 6 et par une valve 7 de la façon représentée sur la figure 1, qui sera détaillée ci-après. L'hélium et l'hydrogène (qui a le rôle de gaz porteur) suivent différents chemins commandés par les valves 8 à 12, les valves 11 et 12 étant utilisées à des fins de purge et de dilution. Trois réservoirs de type classique 13, 14 et 15 contenant des composés halogénés différents sont respectivement disposés dans les chemins commandés par les valves 9, 10 et 8.

Le mélange gazeux composé du gaz halogéné HCl et du gaz porteur H$_2$ commandé par les valves 7 et 8 est introduit dans la chambre 2 par la conduite d'admission 3 et passe sur l'élément le moins volatil, c'est-à-dire la source de gallium 17, formant un gaz de réaction qui est du monochlorure de gallium gazeux.

Dans le chemin commandé par la valve 9, le réservoir 13 contient un composé gazeux qui est du tétrachlorure de germanium maintenu à 0 °C.

Dans le chemin commandé par la valve 10, le réservoir 14 contient un autre composé gazeux qui est du trichlorure d'arsenic maintenu à 25 °C.

Les deux chemins commandés par les valves 9 et 10 se rejoignent au point 18 et les gaz combinés sont introduits dans la chambre 2 par l'intermédiaire de la conduite d'admission 4 dont l'extrémité 19 est située en aval de la source de gallium 17.

On a représenté sur la figure 2 un gradient de température qui est fonction des dimensions du four 1. La source 17 contenant l'élément le moins volatil : le gallium se trouve en amont des substrats 20, lesquels se trouvent donc dans une partie du four dont la température est inférieure à celle de la partie du four où est disposée la source 17.

Du fait de cet agencement, les différents gaz se mélangent au-dessus des substrats 20, tandis que leurs résidus sont ensuite évacués par la conduite 5.

Le procédé de la présente invention consiste essentiellement en fait à utiliser des sources, commandées séparément, de différents éléments qui sont des composés gazeux halogénés à des températures et à des concentrations commandées. Ces composés sont introduits dans une chambre de réaction dont deux parties adjacentes sont maintenues à des températures différentes. Dans la partie « amont » du four qui est maintenue à la température la plus élevée, l'élément le moins volatil, le gallium est en fusion et il circule au-dessus de lui un composé halogéné de réaction qui donne un composé gazeux de gallium. Ces composés se mélangent ensuite dans la partie « aval » de la chambre, qui est maintenue à la température la moins élevée, à proximité des substrats.

La température de la source de gallium 17 dans la chambre 2 peut être maintenue à une valeur comprise entre 750° et 900 °C, et celle de la partie de la chambre dans laquelle sont disposés les substrats 20 peut être comprise entre 600 et 750 °C. On va décrire maintenant comment on réalise le dépôt de façon pratique.

1. Purge par l'hélium — L'hélium est introduit dans la chambre 2 en tant que gaz de purge par les valves 6, 11 et 12. La source de gallium 17 et les substrats 20 (par exemple GaAs monocristallin) sont disposés dans la chambre comme montré, et portés respectivement aux températures mentionnées ci-dessus.

2. Courant d'hydrogène — On ferme ensuite la valve 6 et on ouvre la valve 7, pour établir un courant d'hydrogène.

3. Courant de gallium — Les valves 6, 8, 9 et 10 sont fermées, les valves 7, 11 et 12 sont ouvertes jusqu'à ce que la température d'équilibre soit atteinte.

4. Courant d'arsenic et de germanium — Cinq minutes après, on ouvre les valves 9 (réglées à 2 ml par minute) et 10 (réglée à 50 ml par minute) tandis qu'un débit global de 100 ml par minute est assuré par la valve 11.

5. Courant de germanium — On fait croître graduellement le débit de la valve 9 de 0,3 ml par minute et décroître le débit de la valve 10 également de 0,3 ml par minute. Cela permet d'augmenter graduellement la teneur en germanium de l'arséniure de gallium monocristallin qui se dépose en phase vapeur sur les substrats 20. Après un intervalle de temps de deux heures environ, ou légèrement plus long, la réaction prend fin.

La quantité de germanium incorporée à l'arséniure de gallium augmente au fur et à mesure que la température des substrats diminue.

Lorsque les première et seconde températures des parties « amont » et « aval » de la chambre sont respectivement de 850 °C et de 750 °C, l'arséniure de gallium peut contenir 4 % environ de germanium. Toutefois, si l'on ramène la température des substrats à 700 °C ou à 650 °C tout en maintenant la température de la partie « amont » à 850 °C ou davantage, on peut faire passer la teneur en germanium à 35 %.

Le débit du gaz traversant les réservoirs 13 et 14 peut éventuellement être maintenu à une valeur constante de manière à obtenir une teneur uniforme en germanium.

Le procédé décrit ci-dessus fait appel à l'emploi de plusieurs sources d'éléments halogénés nécessaires aux fins de la réaction, qui peuvent être commandées de façon indépendante en température et en débit. Ces éléments sont ensuite combinés sous une forme gazeuse au-dessus des substrats, de telle sorte que l'élément le moins volatil (ici le gallium) se trouve disposé au-dessous de la conduite d'introduction d'un gaz halogéné (ici HCl + H₂) dans la partie « amont » du four porté à une première température. Cependant que les composés gazeux de l'élément le plus volatil (ici AsCl₃ + H₂), et de l'élément de substitution (ici GeCl₄ + H₂) soient introduits dans la chambre de réaction au-dessus des substrats dans la partie « aval » de la chambre, cette dernière se trouve à une seconde température inférieure à celle de la partie « amont ».

Ce procédé trouve application dans la fabrication de dispositifs émetteurs de lumière bleue.

### Revendications

1. Procédé de dépôt en phase vapeur d'un composé du type $A\, B_{1-x}C_x$ capable d'émettre dans la région bleue du spectre, permettant de commander la concentration des différents éléments constitutifs, du genre comportant les étapes suivantes :

disposer un substrat monocristallin (20) dans la partie aval d'une chambre de réaction horizontale (2) placée dans un four (1), et dans la partie amont de cette chambre, une source (17) de l'élément le moins volatil A,

assurer un premier chemin par des premiers moyens d'introduction (19, 4), pour les composés gazeux qui contiennent les éléments B et C, dont les températures et les débits peuvent être commandés, et

faire réagir un gaz halogène avec l'élément le moins volatil A en fusion par des seconds moyens d'introduction (3) dans la partie « amont » maintenue à une première température T1 pratiquement constante dans toute cette partie, pour fournir un gaz de réaction, et mélanger lesdits gaz de réaction et composés gazeux dans la partie « aval » maintenue à une seconde température T2 pratiquement constante et moins élevée que la première, au-dessus du substrat monocristallin sur lequel on désire déposer le composé du type $A\, B_{1-x}C_x$ caractérisé en ce que les éléments A, B et C sont respectivement le gallium, l'arsenic et le germanium, le substrat monocristallin étant de l'arséniure de gallium et en ce que $\Delta T = T1 - T2$ est supérieur à 100 °C pour que le coefficient x soit $> 0,04$.

2. Procédé selon la revendication 1 caractérisé en ce que lesdits composés gazeux sont des composés halogénés.

3. Procédé selon la revendication 2, caractérisé en ce que les composés gazeux sont respectivement AsCl₃ et GeCl₄ et le gaz halogéné est HCl.

4. Procédé selon la revendication 1, 2, ou 3 caractérisé en ce que les première et seconde températures T1 et T2 qui existent dans les parties « amont » et « aval » dudit four sont telles que T1 ⩾ 850 °C et 600 °C ⩽ T2 ⩽ 750°.

5. Procédé selon la revendication 4, caractérisé en ce que les températures des parties amont et aval sont telles que T1 ⩾ 850 °C et T2 = 600 °C pour que le coefficient x soit de l'ordre de 0,35.

6. Procédé selon l'une des revendications ci-dessus caractérisé en ce que le dépôt est une croissance épitaxiale.

### Claims

1. Process for the vapour phase deposition of a compound of type $A\, B_{1-x}C_x$ which is capable of radiating in the blue area of the spectrum, enabling the control of the concentration of the various constituent elements, of a type comprising the following phases :

place a monocrystalline substrate (20) in the downstream part of a horizontal reaction chamber (2) located in an oven (1), and in the upstream part of this chamber, a source (17) of the least volatile element A,

ensure a first run using the first means of introduction (19, 4) for the gaseous compounds containing the elements B and C, the temperatures and flow rates of which can be controlled, and

cause halogen gas to react with the least volatile element A whilst fused, using the second means of introduction (3) in the « upstream » part maintained at a practically constant first temperature T1 throughout this part, in order to provide a reaction gas, and to mix the aforesaid reaction gases and gaseous compounds in the « downstream » part maintained at a second temperature T2 which is practically constant and lower than the first, over the monocrystalline substrate on which it is desired to deposit the compound of type A $B_{1-x}C_x$, characterized in that the elements A, B and C are gallium, arsenic and germanium respectively, the monocrystalline substrate being gallium arsenide and in that $\Delta T = T1 - T2$ is greater than 100 °C in order that the coefficient x be > 0.04.

2. Process according to claim 1, characterized in that said gaseous compounds are halogen compounds.

3. Process according to claim 2, characterized in that the gaseous compounds are $AsCl_3$ and $GeCl_4$ respectively and the halogen gas is HCl.

4. Process according to claim 1, 2 or 3, characterized in that the first and second temperatures T1 and T2 which are to be found in the « upstream » and « dowstream » parts of said oven are such that T1 ⩾ 850 °C and 600 °C ⩽ T2 ⩽ 750 °C.

5. Process according to claim 4, characterized in that the temperatures of the upstream and downstream parts are such that T1 ⩾ 850 °C and T2 = 600 °C in order that coefficient x be of the order of 0.35.

6. Process according to one of the above claims, characterized in that the deposit it an epitaxial growth.

**Ansprüche**

1. Abscheidungsverfahren aus der Dampfphase einer chemischen Verbindung vom Typ A $B_{1-x}C_x$, die in der Lage ist, im blauen Spektralbereich zu strahlen, wodurch die Steuerung der Konzentration der verschiedenen Bestandteile ermöglicht wird, von der Art, welche die folgenden Teilschritte beinhaltet :

Anordnung eines monokristallinen Substrats (20) im stromabwärts gelegenen Teil einer in einem Ofen (1) aufgestellten horizontalen Reaktionskammer (2) und einer Quelle (17) des am wenigsten volatilen Elements A im stromaufwärts gelegenen Teil dieser Kammer,

Sicherstellung durch erste Einführungsmittel (19, 4) eines ersten Weges für die gasförmigen Verbindungen, welche die Elemente B und C enthalten, deren Temperaturen und Mengen gesteuert werden können, und

Ermöglichung einer Reaktion eines Halogengases mit dem am wenigsten volatilen, sich im geschmolzenen Zustand befindlichen Element A durch zweite Einführungsmittel (3) in den stromaufwärts gelegenen Teil, der bei einer ersten, in diesem ganzen Teil praktisch konstanten Temperatur T1 gehalten wird, um ein Reaktionsgas zu liefern und die genannten Reaktionsgase und gasförmigen Verbindungen in dem stromabwärts gelegenen, bei einer zweiten, praktisch konstanten und weniger hohen als die erste Temperatur T1 gewählten Temperatur T2 gehaltenen Teil oberhalb des monokristallinen Substrats, auf dem man die Verbindung vom Typ A $B_{1-x}C_x$ abzuscheiden wünscht, zu vermischen, dadurch gekennzeichnet, daß die Elemente A, B und C jeweils Gallium, Arsenik und Germanium sind und das monokristalline Substrat Galliumarsenid ist und dadurch, daß $\Delta T = T1 - T2$ höher als 100 °C ist, damit der Koeffizient x > 0,04 ist.

2. Verfahren nach Anspruch 1, dadurch gekennzeichnet, daß die genannten gasförmigen Verbindungen Halogenverbindungen sind.

3. Verfahren nach Anspruch 2, dadurch gekennzeichnet, daß die gasförmigen Verbindungen jeweils $AsCl_3$ und $GeCl_4$ sind, und daß das Halogengas HCl ist.

4. Verfahren nach Anspruch 1, 2 oder 3, dadurch gekennzeichnet, daß die erste und zweite Temperatur T1 und T2, die in den « aufwärts » und « abwärts » gelegenen Teilen des genannten Ofens herrschen, derart sind, daß T1 ⩾ 850 °C und 600 °C ⩽ T2 ⩽ 750 °C.

5. Verfahren nach Anspruch 4, dadurch gekennzeichnet, daß die Temperaturen der « aufwärts » und « abwärts » gelegenen Teile derart sind, daß T1 ⩾ 850 °C und T2 = 600 °C, damit der Koeffizient x in der Grössenordnung von 0,35 liegt.

6. Verfahren nach einem der obigen Ansprüche, dadurch gekennzeichnet, daß die Abscheidung ein epitaktisches Wachstum ist.

FIG. 1

FIG. 2

HCℓ

HCℓ+H₂ →

He

H₂